# EUROPEAN PATENT SPECIFICATION

(11) **EP 1 195 021 B1**
(45) Date of publication and mention of the grant of the patent: **25.10.2006**
(21) Application number: 00926364.1
(22) Date of filing: 24.04.2000
(51) Int. Cl.: H04L 12/00

(54) **PHY CONTROL MODULE FOR A MULTI-PAIR GIGABIT TRANSCEIVER**
PHY-STEUERUNGSMODUL FÜR EINEN GIGABIT-TRANSCEIVER MIT MEHREREN PAAREN
MODULE DE COMMANDE PHY POUR EMETTEUR-RECEPTEUR GIGABIT MULTIPAIRE

(30) Priority: 22.04.1999 US 130616 P; 03.09.1999 US 390856; 09.11.1999 US 437721
(43) Date of publication of application: 10.04.2002
(73) Proprietor: Broadcom Corporation, Irvine, CA 92618 (US)
(72) Inventor: AGAZZI, Oscar E., Irvine, CA 92618 (US)
(74) Representative: Jehle, Volker Armin
(86) International application number: PCT/US2000/011123
(87) International publication number: WO 2000/065772

(56) References cited:
- WO-A-98/09400
- WO-A-99/07077
- AGAZZI O E ET AL: "TWO-PHASE DECIMATION AND JITTER COMPENSATION IN FULL-DUPLEX DATA TRANSCEIVERS" PROCEEDINGS OF THE INTERNATIONAL SYMPOSIUM ON CIRCUITS AND SYSTEMS. (ISCAS),US,NEW YORK, IEEE, vol. CONF. 25, 10 May 1992 (1992-05-10), pages 1717-1720, XP000338277 ISBN: 0-7803-0593-0
- "Local and metropolitan area networks, Specific Requirements, Part 3: Carrier sense multiple access with coillision detection (CSMA/CD) access method and physical layer specifications." 1998 , LAN MAN STANDARDS COMMITTEE OF THE IEEE COMPUTER SOCIETY , USA XP002145257 * 34.1 Overview * * 34.1.1 Reconciliation Sublayer (RS) and Gigabit Medium Independent Interface (GMII). * * Clauses 36.1 to 36.2.2 * * 36.2.5.2.7 Auto-Negotiaiton Process * * 36.3.1. Service Interface of PMA sublayer. * * 36.3.7. Loopback mode * * 36.3.8. Test functions. * figures 34-1,36-1
- HATAMIAN ET AL.: "Design Considerations for Gigabit Ethernet 1000Base-T Twisted Pair Transceivers." CUSTOM INTEGRATED CIRCUITS CONFERENCE, 1998., 11 - 14 May 1998, pages 335-342, XP002145256

## Description

### CROSS-REFERENCE TO RELATED APPLICATIONS

The present invention is a continuation-in-part of the following co-pending applications:
US 6,289,047 entitled "Dynamic Regulation of Power Consumption of a High-Speed Communication System" filed on September 03,1999;
US 6,363,129 entitled "Timing Recovery System for a Multi-Pair Gigabit Transceiver" filed on November 09, 1999.

### BACKGROUND OF THE INVENTION

### 1. FIELD OF THE INVENTION

The present invention relates to a method and a control module for controlling convergence of cancellors, a decision feedback equalizer (DFE) and a timing recovery module.

### 2. DESCRIPTION OF RELATED ART

A transceiver includes a transmitter and a receiver. In a traditional half-duplex transceiver, the transmitter and the receiver can operate with a common clock signal since the transmitting and receiving operations do not occur simultaneously.

In a full-duplex transceiver, the transmitting operation occurs simultaneously with the receiving operation. The full-duplex transceiver needs to operate with at least two clock signals, a transmit clock signal (TCLK) and a sampling clock signal. The TCLK signal is used by the transmitter to regulate transmission of data symbols. The sampling clock signal is used by the receiver to regulate sampling of the received signal at an analog-to digital (A/D) converter. At the local receiver, the frequency and phase of the sampling clock signal are adjusted by a timing recovery system of the local receiver in such a way that they track the transmit clock signal of the remote transmitter. The sampled received signal is demodulated by digital signal processing function blocks of the receiver. These digital processing functions blocks may operate in accordance with either the TCLK signal or the sampling clock signal, provided that signals crossing boundaries between the two clock signals are treated appropriately so that any loss of signal or data samples is prevented.

The IEEE 802.3ab standard (also called 1000BASE-T) for 1 gigabit per second (Gb/s) Ethernet full-duplex communication system specifies that there are four constituent transceivers in a gigabit transceiver and that the full-duplex communication is over four twisted pairs of Category-5 copper cables. Since a Gigabit Ethernet transceiver has four constituent transmitters and four constituent receivers, its operation is much more complex than the operation of a traditional full-duplex transceiver. Power consumption is an important problem that must be addressed. The four twisted pairs of cable may introduce different delays on the signals, causing the signals to have different phases. This, in turn, requires the gigabit Ethernet transceiver to have four A/D converters operating in accordance with four respective sampling clock signals. In addition, the problem of switching noise coupled from the digital signal processing blocks of the gigabit Ethernet transceiver to the four A/D converters must also be addressed.

WO A 98 09400 describes a method of achieving initial convergence of an adaptive decision-feedback equalizer (DFE) in self-training mode. For partial response systems, a linear forward filter of the DFE is implemented as a two-parameter variable analog filter, for which convergence can be achieved prior to timing recovery. For full-response systems, a fully digital adaptive DFE is used and timing recovery is accomplished prior to convergence at the linear forward equalizer.

According to the present invention a method and a control module for controlling convergence of cancellers, a decision feedback equalizer (DFE) and a timing recovery module, as defined by independent claims 1 and 4, respectively, is provided. Further advantageous features of the present invention are defined in the dependent subclaims.

### BRIEF DESCRIPTION OF THE DRAWINGS

The features of the present invention will become more apparent and the invention will be best understood by reference to the following description and the accompanying drawings, wherein:
FIG. 1 is a simplified block diagram of a multi-pair communication system operating in conformance with the IEEE 802.3ab standard (also termed 1000BASE-T) for 1 gigabit (Gb/s) Ethernet full-duplex communication over four twisted pairs of Category-5 copper wires;
FIG. 2 is a simplified block diagram of the functional architecture and internal construction of an embodiment of a gigabit transceiver of FIG. 1;
FIG. 3 is a simplified block diagram of an embodiment of the trellis decoder 38 of FIG. 2;
FIG. 4 shows a flowchart for the ConvergeMasterCancellers substate machine.
FIGS. 5A and 5B shows a flowchart for the ConvergeSlaveCancellers substate machine.
FIGS. 6A and 6B shows a flowchart of the ConvergeMasterDFE substate machine.
FIGS. 7A and 7B shows a flowchart of the ConvergeSlaveDFE substate machine.

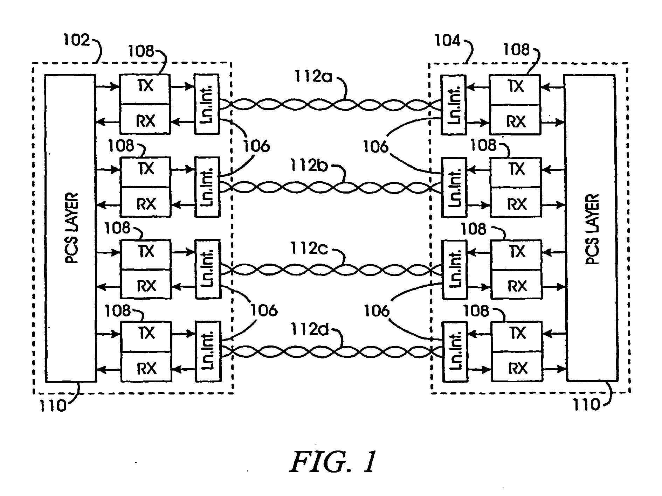

In order to appreciate the advantages of the present invention, it will be beneficial to describe the invention in the context of an exemplary bi-directional communication device, such as an Ethernet transceiver. The particular exemplary implementation chosen is depicted in FIG. 1, which is a simplified block diagram of a multi-pair communication system operating in conformance with the IEEE 802.3ab standard (also termed 1000BASE-T) for 1 gigabit (Gb/s) Ethernet full-duplex communication over four twisted pairs of Category-5 copper wires.

In FIG. 1, the communication system is represented as a point-to-point system in order to simplify the explanation, and includes two main transceiver blocks 102 and 104, coupled together via four twisted-pair cables 112a, b, c and d. Each of the wire pairs 112a, b, c, d is coupled to each of the transceiver blocks 102, 104 through a respective one of four line interface circuits 106. Each of the wire pairs 112a, b, c, d facilitates communication of information between corresponding pairs of four pairs of transmitter/receiver circuits (constituent transceivers) 108. Each of the constituent transceivers 108 is coupled between a respective line interface circuit 106 and a Physical Coding Sublayer (PCS) block-110. At each of the transceiver blocks 102 and 104, the four constituent transceivers 108 are capable of operating simultaneously at 250 megabits of information data per second (Mb/s) each, i.e., 125 Mbaud at 2 information data bits per symbol, the 2 information data bits being encoded in one of the 5 levels of the PAM-5 (Pulse Amplitude Modulation) alphabet. The four constituent transceivers 108 are coupled to the corresponding remote constituent transceivers through respective line interface circuits to facilitate full-duplex bi-directional operation. Thus, 1Gb/s communication throughput of each of the transceiver blocks 102 and 104 is achieved by using four 250 Mb/s constituent transceivers 108 for each of the transceiver blocks 102, 104 and four pairs of twisted copper cables to connect the two transceiver blocks 102, 104 together.

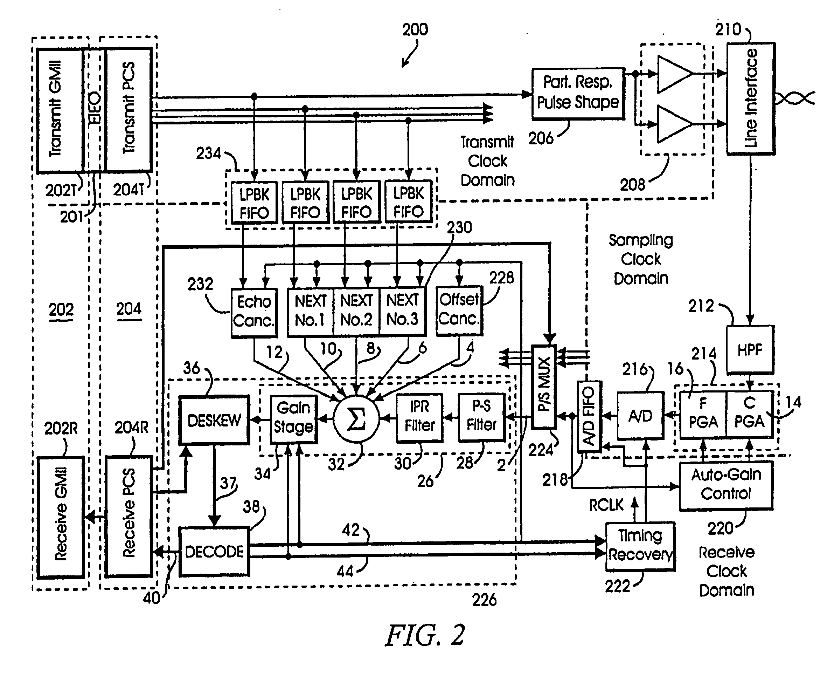

FIG. 2 is a simplified block diagram of the functional architecture and internal construction of an exemplary transceiver block, indicated generally at 200, such as transceiver 101 of FIG. 1. Since the illustrative transceiver application relates to gigabit Ethernet transmission, the transceiver will be referred to as the "gigabit transceiver". For ease of illustration and description, FIG. 2 shows only one of the four 250 Mb/s constituent transceivers which are operating simultaneously (termed herein 4-D operation). However, since the operation of the four constituent transceivers are necessarily interrelated, certain blocks and signal lines in the exemplary embodiment of FIG. 2 perform four-dimensional operations and carry four-dimensional (4-D) signals, respectively. By 4-D, it is meant that the data from the four constituent transceivers are used simultaneously. In order to clarify signal relationships in FIG. 2, thin lines correspond to 1-dimensional functions or signals (i.e., relating to only a single constituent transceiver), and thick lines correspond to 4-D functions or signals (relating to all four constituent transceivers).

Referring to FIG. 2, the gigabit transceiver 200 includes a Gigabit Medium Independent Interface (GMII) block 202 subdivided into a receive GMII circuit 202R and a transmit GMII circuit 202T. The transceiver also includes a Physical Coding Sublayer (PCS) block 204, subdivided into a receive PCS circuit 204R and a transmit PCS circuit 204T, a pulse shaping filter 206, a digital-to analog (D/A) converter block 208, and a line interface block 210, all generally encompassing the transmitter portion of the transceiver.

The receiver portion generally includes a highpass filter 212, a programmable gain amplifier (PGA) 214, an analog-to-digital (A/D) converter 216, an automatic gain control (AGC) block 220, a timing recovery block 222, a pair-swap multiplexer block 224, a demodulator 226, an offset canceller 228, a near-end crosstalk (NEXT) canceller block 230 having three constituent NEXT cancellers and an echo canceller 232.

The gigabit transceiver 200 also includes an A/D first-in-first-out buffer (FIFO) 218 to facilitate proper transfer of data from the analog clock region to the receive clock region, and a loopback FIFO block (LPBK) 234 to facilitate proper transfer of data from the transmit clock region to the receive clock region. The gigabit transceiver 200 can optionally include an additional adaptive filter to cancel far-end crosstalk noise (FEXT canceller).

In operational terms, on the transmit path, the transmit section 202T of the GMII block receives data from the Media Access Control (MAC) module in byte-wide format at the rate of 125 MHz and passes them to the transmit section 204T of the PCS block via the FIFO 201. The FIFO 201 ensures proper data transfer from the MAC layer to the Physical Coding (PHY) layer, since the transmit clock of the PHY layer is not necessarily synchronized with the clock of the MAC layer. In one embodiment, this small FIFO 201 has from about three to about five memory cells to accommodate the elasticity requirement which is a function of frame size and frequency offset.

The PCS transmit section 204T performs certain scrambling operations and, in particular, is responsible for encoding digital data into the requisite codeword representations appropriate for transmission. In the illustrated embodiment of FIG. 2, the transmit PCS section 204T incorporates a coding engine and signal mapper that implements a trellis coding architecture, such as required by the IEEE 802.3ab specification for gigabit transmission.

In accordance with this encoding architecture, the PCS transmit section 204T generates four 1-D symbols, one for each of the four constituent transceivers. The 1-D symbol generated for the constituent transceiver depicted in FIG. 2 is filtered by the pulse shaping filter 206. This filtering assists in reducing the radiated emission of the output of the transceiver such that it falls within the parameters required by the Federal Communications Commission. The pulse shaping filter 206 is implemented so as to define a transfer function of 0.75 +0.25z⁻¹. This particular implementation is chosen so that the power spectrum of the output of the transceiver falls below the power spectrum of a 100Base-Tx signal. The 100Base-Tx is a widely used and accepted Fast Ethernet standard for 100 Mb/s operation on two pairs of Category-5 twisted pair cables. The output of the pulse shaping filter 206 is converted to an analog signal by the D/A converter 208 operating at 125 MHz. The analog signal passes through the line interface block 210, and is placed on the corresponding twisted pair cable.

On the receive path, the line interface block 210 receives an analog signal from the twisted pair cable. The received analog signal is preconditioned by the highpass filter 212 and the PGA 214 before being converted to a digital signal by the A/D converter 216 operating at a sampling rate of 125 MHz. The timing of the A/D converter 216 is controlled by the output of the timing recovery block 222. The resulting digital signal is properly transferred from the analog clock region to the receive clock region by the A/D FIFO 218. The output of the A/D FIFO 218 is also used by the AGC 220 to control the operation of the PGA 214.

The output of the A/D FIFO 218, along with the outputs from the A/D FIFOs of the other three constituent transceivers are inputted to the pair-swap multiplexer block 224. The pair-swap multiplexer block 224 uses the 4-D pair-swap control signal from the receive section 204R of PCS block to sort out the four input signals and send the correct signals to the respective feedforward equalizers 26 of the demodulator 226. This pair-swapping control is needed for the following reason. The trellis coding methodology used for the gigabit transceivers (101 and 102 of FIG. 1) is based on the fact that a signal on each twisted pair of wire corresponds to a respective 1-D constellation, and that the signals transmitted over four twisted pairs collectively form a 4-D constellation. Thus, for the decoding to work, each of the four twisted pairs must be uniquely identified with one of the four dimensions. Any undetected swapping of the four pairs would result in erroneous decoding. In an alternate embodiment of the gigabit transceiver, the pair-swapping control is performed by the demodulator 226, instead of the combination of the PCS receive section 204R and the pair-swap multiplexer block 224.

The demodulator 226 includes a feed-forward equalizer (FFE) 26 for each constituent transceiver, coupled to a deskew memory circuit 36 and a decoder circuit 38, implemented in the illustrated embodiment as a trellis decoder. The deskew memory circuit 36 and the trellis decoder 38 are common to all four constituent transceivers. The FFE 26 receives the received signal intended for it from the pair-swap multiplexer block 224. The FFE 26 is suitably implemented to include a precursor filter 28, a programmable inverse partial response (IPR) filter 30, a summing device 32, and an adaptive gain stage 34. The FFE 26 is a least-mean-squares (LMS) type adaptive filter which is configured to perform channel equalization as will be described in greater detail below.

The precursor filter 28 generates a precursor to the input signal 2. This precursor is used for timing recovery. The transfer function of the precursor filter 28 might be represented as -γ +z⁻¹, with γ equal to 1/16 for short cables (less than 80 meters) and 1/8 for long cables (more than 80 m). The determination of the length of a cable is based on the gain of the coarse PGA 14 of the programmable gain block 214.

The programmable IPR filter 30 compensates the ISI (intersymbol interference) introduced by the partial response pulse shaping in the transmitter section of a remote transceiver which transmitted the analog equivalent of the digital signal 2. The transfer function of the IPR filter 30 may be expressed as 1/(1+Kz⁻¹). In the present example, K has an exemplary value of 0.484375 during startup, and is slowly ramped down to zero after convergence of the decision feedback equalizer included inside the trellis decoder 38. The value of K may also be any positive value strictly less than 1.

The summing device 32 receives the output of the IPR filter 30 and subtracts therefrom adaptively derived cancellation signals received from the adaptive filter block, namely signals developed by the offset canceller 228, the NEXT cancellers 230, and the echo canceller 232. The offset canceller 228 is an adaptive filter which generates an estimate of signal offset introduced by component circuitry of the transceiver's analog front end, particularly offsets introduced by the PGA 214 and the A/D converter 216.

The three NEXT cancellers 230 may also be described as adaptive filters and are used, in the illustrated embodiment, for modeling the NEXT impairments in the received signal caused by interference generated by symbols sent by the three local transmitters of the other three constituent transceivers. These impairments are recognized as being caused by a crosstalk mechanism between neighboring pairs of cables, thus the term near-end crosstalk, or NEXT. Since each receiver has access to the data transmitted by the other three local transmitters, it is possible to approximately replicate the NEXT impairments through filtering. Referring to FIG. 2, the three NEXT cancellers 230 filter the signals sent by the PCS block to the other three local transmitters and produce three signals replicating the respective NEXT impairments. By subtracting these three signals from the output of the IPR filter 30, the NEXT impairments are approximately cancelled.

Due to the bi-directional nature of the channel, each local transmitter causes an echo impairment on the received signal of the local receiver with which it is paired to form a constituent transceiver. In order to remove this impairment, an echo canceller 232 is provided, which may also be characterized as an adaptive filter, and is used, in the illustrated embodiment, for modeling the signal impairment due to echo. The echo canceller 232 filters the signal sent by the PCS block to the local transmitter associated with the receiver, and produces an approximate replica of the echo impairment. By subtracting this replica signal from the output of the IPR filter 30, the echo impairment is approximately cancelled.

The adaptive gain stage 34 receives the processed signal from the summing circuit 32 and fine tunes the signal path gain using a zero-forcing LMS algorithm. Since this adaptive gain stage 34 trains on the basis of error signals generated by the adaptive filters 228, 230 and 232, it provides a more accurate signal gain than the one provided by the PGA 214 in the analog section.

The output of the adaptive gain stage 34, which is also the output of the FFE 26, is inputted to the deskew memory circuit 36. The deskew memory 36 is a four-dimensional function block, i.e., it also receives the outputs of the three FFEs of the other three constituent transceivers. There may be a relative skew in the outputs of the four FFEs, which are the four signal samples representing the four symbols to be decoded. This relative skew can be up to 50 nanoseconds, and is due to the variations in the way the copper wire pairs are twisted. In order to correctly decode the four symbols, the four signal samples must be properly aligned. The deskew memory aligns the four signal samples received from the four FFEs, then passes the deskewed four signal samples to a decoder circuit 38 for decoding.

In the context of the exemplary embodiment, the data received at the local transceiver was encoded before transmission, at the remote transceiver. In the present case, data might be encoded using an 8-state four-dimensional trellis code, and the decoder 38 might therefore be implemented as a trellis decoder. In the absence of intersymbol interference (ISI), a proper 8-state Viterbi decoder would provide optimal decoding of this code. However, in the case of Gigabit Ethernet, the Category-5 twisted pair cable introduces a significant amount of ISI. In addition, the partial response filter of the remote transmitter on the other end of the communication channel also contributes some ISI. Therefore, the trellis decoder 38 must decode both the trellis code and the ISI, at the high rate of 125 MHz. In the illustrated embodiment of the gigabit transceiver, the trellis decoder 38 includes an 8-state Viterbi decoder, and uses a decision-feedback sequence estimation approach to deal with the ISI components.

The 4-D output of the trellis decoder 38 is provided to the PCS receive section 204R. The receive section 204R of the PCS block de-scrambles and decodes the symbol stream, then passes the decoded packets and idle stream to the receive section 202T of the GMII block which passes them to the MAC module. The 4-D outputs, which are the error and tentative decision, respectively, are provided to the timing recovery block 222, whose output controls the sampling time of the A/D converter 216. One of the four components of the error and one of the four components of the tentative decision correspond to the receiver shown in FIG. 2, and are provided to the adaptive gain stage 34 of the FFE 26 to adjust the gain of the equalizer signal path. The error component portion of the decoder output signal is also provided, as a control signal, to adaptation circuitry incorporated in each of the adaptive filters 230 and 232. Adaptation circuitry is used for the updating and training process of filter coefficients.

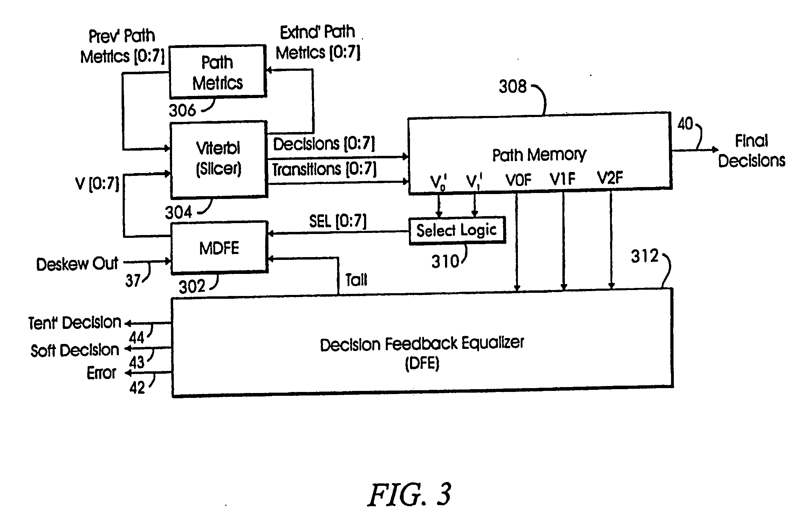

Figure 3 is a block diagram of the trellis decoder 38 of Figure 2. The trellis decoder 38 includes a multiple decision feedback equalizer (MDFE) 302, a Viterbi decoder 304, a path metrics module 306, a path memory module 308, a select logic 310, and a decision feedback equalizer 312.

The Viterbi decoder 304 performs 4D slicing of the Viterbi inputs provided by the MDFE 302 and computes the branch metrics. Based on the branch metrics and the previous path metrics received from the path metrics module 306, the Viterbi decoder 304 extends the paths and computes the extended path metrics. The Viterbi decoder 304 selects the best path incoming to each of the 8 states, updates the path memory stored in the path memory module 308 and the path metrics stored in the path metrics module 306.

The computation of the final decision and the tentative decisions are performed in the path memory module 308 based on the 4D symbols stored in the path memory for each state. At each iteration of the Viterbi algorithm, the best of the 8 states, i.e., the one associated with the path having the lowest path metric, is selected, and the 4D symbol from the associated path stored at the last level of the path memory is selected as the final decision 40 and provided to the receive section of the PCS 204R (FIG. 2). Symbols at lower depth levels are selected as tentative decisions, which are used to feed the delay line of the DFE 312.

The number of the outputs Vᵢ to be used as tentative decisions depends on the required accuracy and speed of decoding operation. A delayed version of V_{0F} is provided as the 4D tentative decision 44 (FIG. 2) to the Feed-Forward Equalizers 26 of the 4 constituent transceivers and the timing recovery block 222 (FIG. 2).

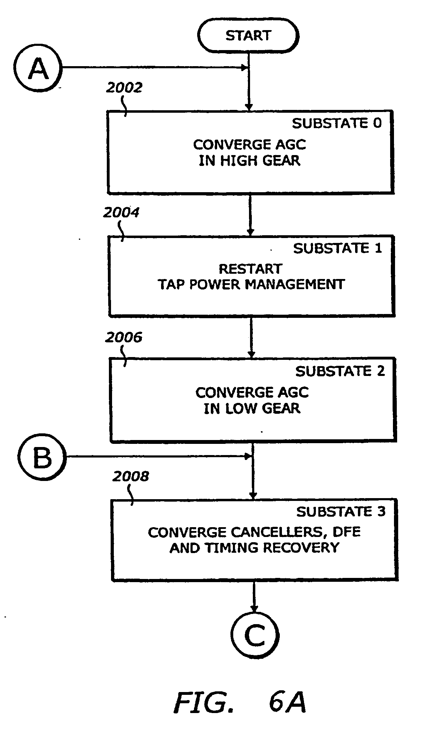

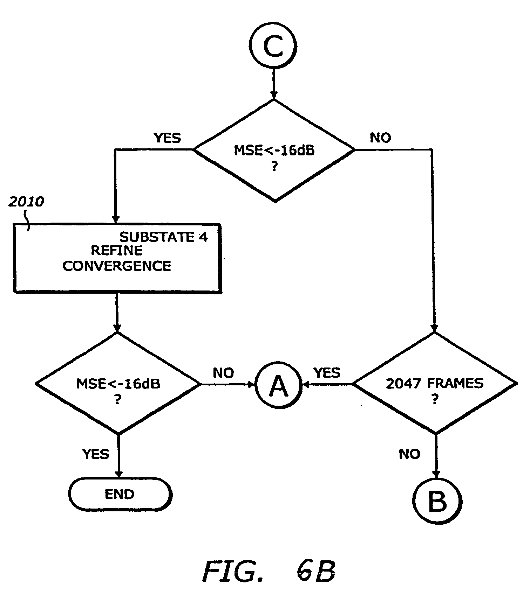

Based on the symbols V_{0F}, V_{1F}, and V_{2F}, the DFE 612 produces the intersymbol interference (ISI) replica associated with all previous symbols except the two most recent (since it was derived without using the first two taps of the DFE 612). The ISI replica is fed to the MDFE 302 (this ISI replica is denoted as the "tail component" in FIG. 6). The MDFE 302 computes the ISI replica associated with all previous symbols including the two most recent symbols, subtracts it from the output 37 of the deskew memory block 36 (FIG. 2) and provides the resulting Viterbi inputs to the Viterbi decoder 304.

The DFE 312 also computes an ISI replica associated with the two most recent symbols, based on tentative decisions V_{0F}, V_{1F}, and V_{2F}. This ISI replica is subtracted from a delayed version of the output 37 of the de-skew memory block 36 to provide the soft decision 43. The tentative decision V_{0F} is subtracted from the soft decision 43 to provide the error 42. There 3 different versions of the error 42, which are 42enc, 42ph and 42dfe. The error 42enc is provided to the echo cancellers and NEXT cancellers of the constituent transceivers. The error 42ph is provided to the FFEs 26 (FIG. 2) of the 4 constituent transceivers and the timing recovery block 222. The error 42dfe is used for the adaptation of the coefficients of the DFE 312. The tentative decision 44 shown in Figure 3 is a delayed version of V_{0F}. The soft decision 43 is only used for display purposes.

For the exemplary gigabit transceiver system 200 described above and shown in FIG. 2, there are design considerations regarding the allocation of boundaries of the clock domains. These design considerations are dependent on the clocking relationship between transmitters and receivers in a gigabit transceiver. Therefore, this clocking relationship will be discussed first.

During a bidirectional communication between two gigabit transceivers 101, 102 (FIG. 1), through a process called "auto-negotiation", one of the gigabit transceivers assumes the role of the master while the other assumes the role of the slave. When a gigabit transceiver assumes one of the two roles with respect to the remote gigabit transceiver, each of its constituent transceivers assumes the same role with respect to the corresponding one of the remote constituent transceivers. Each constituent transceiver 108 is constructed such that it can be dynamically configured to act as either the master or the slave with respect to a remote constituent transceiver 108 during a bidirectional communication. The clocking relationship between the transmitter and receiver inside the constituent transceiver 108 depends on the role of the constituent transceiver (i.e., master or slave) and is different for each of the two cases.

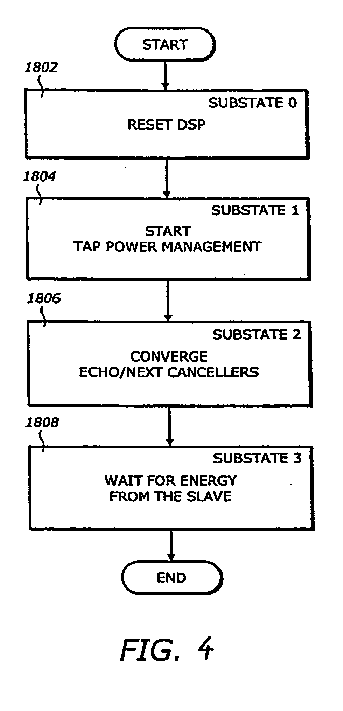

FIG. 4 shows a flowchart for the ConvergeMasterCancellers substate machine. Upon start, the ConvergeMasterCancellers substate machine resets the DSP module (block 1802). It then starts the Tap Power Management state machine (block 1804). Then it controls convergence of the Echo/NEXT cancellers (block 1806). Then it waits for detection of energy from the Slave gigabit transceiver (block 1808). It then terminates.

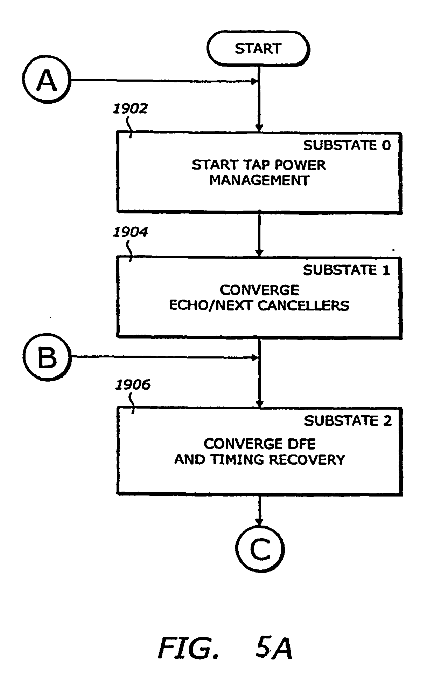

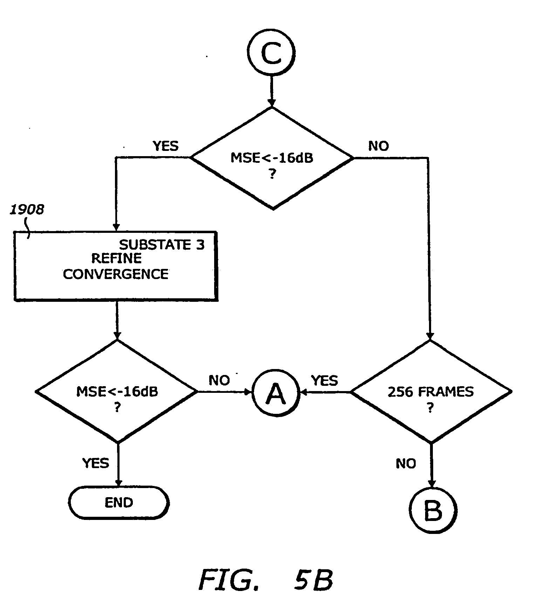

FIGS. 5A and 5B shows a flowchart for the ConvergeSlaveCancellers substate machine. Upon start, the ConvergeSlaveCancellers substate machine starts the Tap Power Management state machine (block 1902). Then it controls convergence of the Echo/NEXT cancellers (block 1904). Then it controls convergence of the DFE and Timing Recovery (block 1906).

If the mean squared error (MSE) is less than -16 dB then the ConvergeSlaveCancellers substate machine refines the convergence (block 1908). After the convergence is refined, if the MSE stays below -16 dB then the ConvergeSlaveCancellers substate machine terminates, otherwise, it goes back to block 1902 to start over again.

While in block 1906, if the MSE is not less than -16 dB and the convergence process has lasted 256 frames, then the ConvergeSlaveCancellers substate goes back to block 1902 to start over again. If the MSE is not less than -16 dB and the convergence process has lasted less than 256 frames, then the ConvergeSlaveCancellers substate stays in block 1906 to continue the convergence of the DFE and Timing Recovery.

FIGS. 6A and 6B shows a flowchart of the ConvergeMasterDFE substate machine. Upon start, the ConvergeMasterDFE substate machine converges the AGC 220 (FIG. 2) in high gear (block 2002). Then it restarts the Tap Power Management state machine (block 2004). Then it converges the AGC in low gear (block 2006).

Then the ConvergeMasterDFE substate machine controls convergence of the Echo/NEXT cancellers, the DFE and the Timing Recovery (block 2008).

If the MSE is less than -16 dB then the ConvergeMasterDFE substate machine refines the convergence (block 2010). After the convergence is refined, if the MSE stays below -16 dB then the ConvergeMasterDFE substate machine terminates, otherwise, it goes back to block 2002 to start over again.

While in block 2008, if the MSE is not less than -16 dB and the convergence process has lasted 2047 frames, then the ConvergeMasterDFE substate machine goes back to block 2002 to start over again. If the MSE is not less than -16 dB and the convergence process has lasted less than 256 frames, then the ConvergeMasterDFE substate machine stays in block 2008 to continue the convergence of the Echo/NEXT cancellers, the DFE and the Timing Recovery.

It is important to note that in block 2003, the ConvergeMasterDFE substate machine tries to converge three different blocks, namely, the cancellers, the DFE and the Timing Recovery. It is very difficult to converge all three at the same time. The DFE and the Timing Recovery are both decision-directed, i.e., directed by the decisions from the decoder 38 (FIG. 2). In addition, the cancellers cannot be decoupled from the DFE and the Timing Recovery because, at the Master, the TCLK signal and the RCLK signals are not in phase lock. Thus, even if the cancellers are converged first, their coefficients will change significantly when the convergence of the DFE and the Timing Recovery starts.

The solution to this problem is an important feature of the ConvergeMasterDFE substate machine. In block 2008, the Timing Recovery is decoupled from the cancellers and the DFE to facilitate the convergence of these two blocks. This is done as follows. The cancellers and the DFE are allowed to converge normally while the phase output of Timing Recovery is ramped up linearly and very slowly (about 2 ppm). In block 2008, the Timing Recovery is running in open loop mode. Because the Timing Recovery phase output is changing very slowly and linearly, the cancellers can converge and reoonverge easily. The DFE only converges at the correct phase. Near the correct phase, the signal-to-noise ratio quickly improves. Near the correct phase, the MSE will be less than -16 dB. After the cancellers and the DFE converge, in block 2010, the ConvergeMasterDFE substate machine refines the convergence by allowing the cancellers, the DFE and the Timing Recovery to converge normally. In block 2010, the Timing Recovery is operated in closed loop mode. This novel feature can be used for any transceiver.

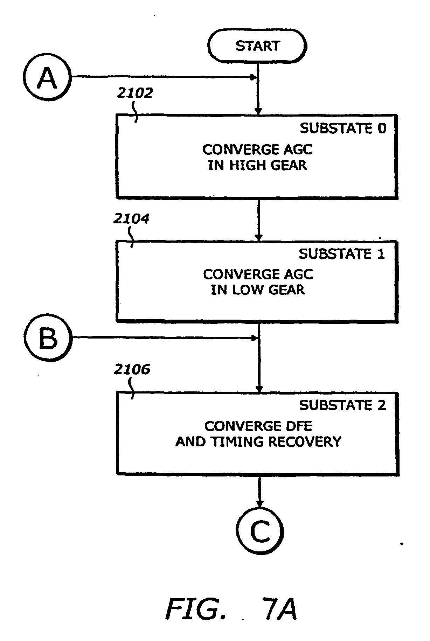

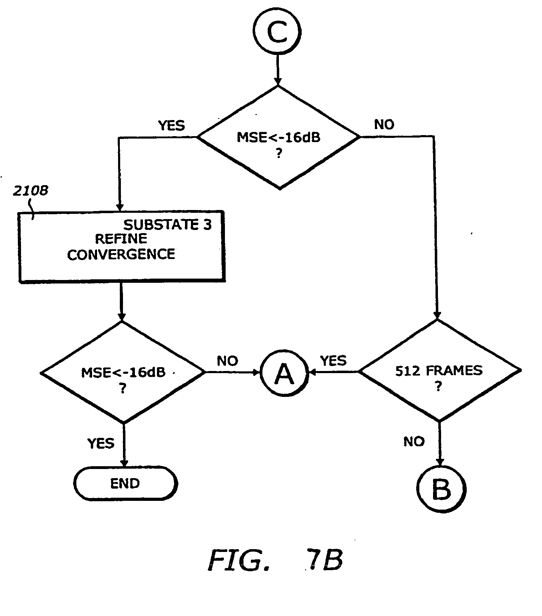

FIGS. 7A and 7B shows a flowchart of the ConvergeSlaveDFE substate machine. Upon start, the ConvergeSlaveDFE substate machine converges the AGC 220 (FIG. 2) in high gear (block 2102). Then it converges the AGC in low gear (block 2104).

Then the ConvergeSlaveDFE substate machine controls convergence of the DFE and the Timing Recovery (block 2106).

If the MSE is less than -16 dB then the ConvergeSlaveCancellers substate machine refines the convergence (block 2108). After the convergence is refined, if the MSE stays below -16 dB then the ConvergeSlaveCancellers substate machine terminates, otherwise, it goes back to block 2102 to start over again.

While in block 2106, if the MSE is not less than -16 dB and the convergence process has lasted 512 frames, then the ConvergeSlaveCancellers substate goes back to block 2102 to start over again. If the MSE is not less than -16 dB and the convergence process has lasted less than 256 frames, then the ConvergeSlaveCancellers substate stays in block 2106 to continue the convergence of the Echo/NEXT cancellers, the DFE and the Timing Recovery.

While certain exemplary embodiments have been described in detail and shown in the accompanying drawings, it is to be understood that such embodiments are merely illustrative of and not restrictive on the broad invention. It will thus be recognized that various modifications may be made to the illustrated and other embodiments of the invention described above, without departing from the broad inventive scope thereof.

## Claims

1. A method for controlling convergence of cancellers, a decision feedback equalizer DFE (312) and a timing recovery module (222),
**characterized in that** the method comprises the operation of:
(a) decoupling the timing recovery module (222) from the cancellers (228, 230, 232) and the DFE (312) while converging the cancellers (228, 230, 232) and the DFE (312) at the same time.

2. The method of claim 1, further comprising the operation of:
(b) converging the cancellers (228, 230, 232), the DFE (312) and the timing recovery module (222) at the same time after the cancellers (228, 230, 232) and the DFE (312) have converged.

3. The method of claim 1 wherein the operation (a) comprises the operation of ramping up linearly the phase output of the timing recovery module (222).

4. A control module for controlling convergence of cancellers, a decision feedback equalizer DFE (312) and a timing recovery module (222),
**characterized in that**
the control module comprises a state machine for de-coupling the timing recovery module (222) from the cancellers (228, 230, 232) and the DFE (312) while converging the cancellers (228, 230, 232) and the DFE (312) at the same time.

5. The control module of claim 4, wherein the state machine is adapted to converge the cancellers (228, 230, 232), the DFE (312) and the timing recovery module (222) at the same time after converging the cancellers (228, 230, 232) and the DFE (312).

6. The control module of claim 4 wherein the state machine is adapted to de-couple the timing recovery module (222) by use of ramping up linearly the phase output of the timing recovery module (222).

## Patentansprüche

1. Verfahren zum Steuern der Konvergenz von Cancellern, eines entscheidungsrückgekoppelten Entzerrers (Decision Feedback Equalizer) DFE (312) und eines Timing Recovery Moduls (222),
**dadurch gekennzeichnet, dass** das Verfahren folgende Operation umfasst:
(a) Entkoppeln des Timing Recovery Moduls (222) von den Cancellern (228, 230, 232) und dem DFE (312), während gleichzeitig die Canceller (228, 230, 232) und der DFE (312) konvergiert werden.

2. Verfahren nach Anspruch 1, das des Weiteren die folgende Operation umfasst:
(b) Gleichzeitiges Konvergieren der Canceller (228, 230, 232), des DFE (312) und des Timing Recovery Moduls (222), nachdem die Canceller (228, 230, 232) und der DFE (312) konvergiert haben.

3. Verfahren nach Anspruch 1, wobei die Operation (a) die Operation des linearen Aufstockens des Phasenausgangs des Timing Recovery Moduls (222) umfasst.

4. Steuerungsmodul zum Steuern der Konvergenz von Cancellern, eines entscheidungsrückgekoppelten Entzerrers (Decision Feedback Equalizer) DFE (312) und eines Timing Recovery Moduls (222),
**dadurch gekennzeichnet, dass**
das Steuerungsmodul eine Zustandsmaschine zum Entkoppeln des Timing Recovery Moduls (222) von den Cancellern (228, 230, 232) und dem DFE (312) aufweist, während gleichzeitig die Canceller (228, 230, 232) und der DFE (312) konvergiert werden.

5. Steuerungsmodul nach Anspruch 4, wobei die Zustandsmaschine so ausgestaltet ist, dass sie die Canceller (228, 230, 232), den DFE (312) und das Timing Recovery Modul (222) gleichzeitig nach dem Konvergieren der Canceller (228, 230, 232) und der DFE (312) konvergiert.

6. Steuerungsmodul nach Anspruch 4, wobei die Zustandsmaschine so ausgestaltet ist, dass sie das Timing Recovery Modul (222) mittels linearen Aufstockens des Phasenausgangs des Timing Recovery Moduls (222) entkoppelt.

## Revendications

1. Procédé destiné à commander la convergence de dispositifs d'annulation, d'un correcteur de phase avec demande de répétition DFE (312) et d'un module de récupération du rythme (222),
**caractérisé en ce que** le procédé comprend l'opération de :
(a) découplage du module de récupération du rythme (222) provenant des dispositifs d'annulation (228, 230, 232) et du DFE (312) tout en faisant converger les dispositifs d'annulation (228, 230, 232) et le DFE (312) en même temps.

2. Procédé selon la revendication 1, comprenant en outre l'opération de :
(b) faire converger les dispositifs d'annulation (228, 230, 232), le DFE (312) et le module de récupération du rythme (222) en même temps après que les dispositifs d'annulation (228, 230, 232) et le DFE (312) ont convergé.

3. Procédé selon la revendication 1, dans lequel l'opération (a) comprend l'opération d'augmentation par rampe linéaire de la sortie de phase du module de récupération du rythme (222).

4. Module de commande destiné à commander la convergence de dispositifs d'annulation, d'un correcteur de phase avec demande de répétition DFE (312) et d'un module de récupération du rythme (222),
**caractérisé en ce que**
le module de commande comprend une machine d'état destinée à découpler le module de récupération du rythme (222) des dispositifs d'annulation (228, 230, 232) et du DFE (312) tout en faisant converger les dispositifs d'annulation (228, 230, 232) et le DFE (312) en même temps.

5. Module de commande selon la revendication 4, dans lequel la machine d'état est adaptée pour faire converger les dispositifs d'annulation (228, 230, 232), le DFE (312) et le module de récupération du rythme (222) en même temps après convergence des dispositifs d'annulation (228, 230, 232) et du DFE (312).

6. Module de commande selon la revendication 4, dans lequel la machine d'état est adaptée pour découpler le module de récupération du rythme (222) par utilisation de l'augmentation par rampe linéaire de la sortie de phase du module de récupération du rythme (222).
